Europäisches Patentamt

European Patent Office

Office européen des brevets

(11) Publication number: **0 327 340 B1**

# EUROPEAN PATENT SPECIFICATION

(45) Date of publication of patent specification: **06.10.93**  (51) Int. Cl.5: **G11C 8/00**

(21) Application number: **89300971.2**

(22) Date of filing: **01.02.89**

(54) **Decoder circuit.**

(30) Priority: **02.02.88 JP 22285/88**

(43) Date of publication of application:
**09.08.89 Bulletin 89/32**

(45) Publication of the grant of the patent:
**06.10.93 Bulletin 93/40**

(84) Designated Contracting States:
**DE FR GB**

(56) References cited:

PATENT ABSTRACTS OF JAPAN, vol. 7, no.
78 (P-188)[1223], 31st March 1983; & JP-A-58
6589

PATENT ABSTRACTS OF JAPAN, vol. 10, no.
283 (E-440)[2339], 26th September 1986; &
JP-A-61 101 124

(73) Proprietor: **FUJITSU LIMITED**
**1015, Kamikodanaka**
**Nakahara-ku**
**Kawasaki-shi Kanagawa 211(JP)**

(72) Inventor: **Iwazaki, Tomonobu**
**6-16-4, Nishitsuruma**
**Yamato-shi Kanagawa 242(JP)**

(74) Representative: **Billington, Lawrence Emlyn et**
**al**
**HASELTINE LAKE & CO**
**Hazlitt House**
**28 Southampton Buildings**
**Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to a decoder circuit, more particularly, to an output portion or a buffer portion of a dynamic type decoder circuit used for selecting a memory cell of a memory device.

In the prior art, a decoder circuit is used for decoding an input signal, and selecting and outputting a signal on one of a plurality of signal conductors. A decoder circuit is used for various purposes, but in the example given below, the decoder circuit is used for selecting a memory cell of a memory such as a ROM (Read Only Memory) or PLA (Programmable Logic Array), and the like.

For example, one type of decoder circuit comprises a decoder portion, a buffer portion, and a control portion. The decoder portion includes input signal conductors and output signal conductors, the input signal conductors being complemental signal conductors and the output signal conductors being provided so as to cross the input signal conductors. A cell transistor is provided for each crossed portion of the input signal conductors and the output signal conductors, and one of the output signal conductors is selected in accordance with a decoded logic of the contents of the input signals. Output portions of the output signal conductors are provided, for example, with NAND circuits, and the input terminal of each of the NAND circuits is connected to one of the output signal conductors and the other input terminal thereof is supplied with a timing signal. This timing signal is input to the other input terminals thereof after changing a potential of the output signal conductors, except one selected output signal conductor, to a low level. Namely, the timing signal is used to avoid a selection error, and this timing signal is output from a control portion in the decoder circuit. The control portion comprises, for example, an inverter having an input supplied with a potential of a dummy signal conductor wired in the same manner as the output signal conductors, a NAND circuit, and an inverter.

The above type of decoder circuit has problems in that the timing signal should be applied to the NAND circuit, and the word lines should be driven by the timing signal through the NAND circuit in the output portions of the output signal conductors. Namely, the timing signal should be generated after all unselected output signal conductors have been fully discharged. Therefore, an output timing of the timing signal must include a time margin, taking into consideration a discharge time for fully discharging an electrical charge in each of the output signal conductors, whereby a drive timing of the word line corresponding to the selected output signal conductor is delayed and thus hinders a high speed operation of the decoder circuit. Further, the NAND circuits in the output portions of the output signal conductors and the control portions must be provided, and thus the construction of the decoder circuit becomes complicated.

According to the present invention, there is provided a decoder circuit including a plurality of signal conductors, a first potential setting means connected to said signal conductors and operable to set a potential of said signal conductors at a first potential, and a second potential setting means connected to said signal conductors and operable to maintain a potential of one of said signal conductors at said first potential and to reduce a potential of remaining said signal conductors to a second potential, characterized in that said decoder circuit comprises:

a respective transfer transistor provided for each signal conductor, a gate electrode of each transfer transistor being connected to the corresponding signal conductor, a source electrode thereof being connected to another signal conductor, whereby in use, one of said transfer transistors is switched ON and a decoded output signal output when a gate potential of that transfer transistor is maintained at said first potential and a source potential thereof is brought to said second potential.

An embodiment of the present invention may provide a decoder circuit having a simple configuration, a high speed operation and stable operation, and suitable for application to a large scale integration circuit.

Reference will now be made, by way of example, to the accompanying drawings in which:

Figure 1 is a block diagram showing one example of a decoder circuit applied to a read only memory;

Fig. 2 is a circuit diagram showing one example of the decoder circuit shown in Fig. 1;

Fig. 3 is a timing chart explaining an operation of the decoder circuit shown in Fig. 2;

Fig. 4 is a block diagram showing one embodiment of a decoder circuit according to the present invention;

Fig. 5 is a circuit diagram showing one embodiment of the decoder circuit as shown in Fig. 4;

Fig. 6 is a circuit diagram showing a modification of the embodiment of the decoder circuit as shown in Fig. 5;

Fig. 7 is a circuit diagram showing another modification of the embodiment of the decoder circuit as shown in Fig. 5; and,

Fig. 8 is a timing chart explaining an operation of the circuit shown in Fig. 5.

A decoder circuit is used for decoding input signals, and selecting and outputting one of a plurality of signal conductors. The decoder circuit is used for various purposes, but in the given below example, the decoder circuit is used for selecting a memory cell of a memory such as a ROM (Read Only Memory), and the like.

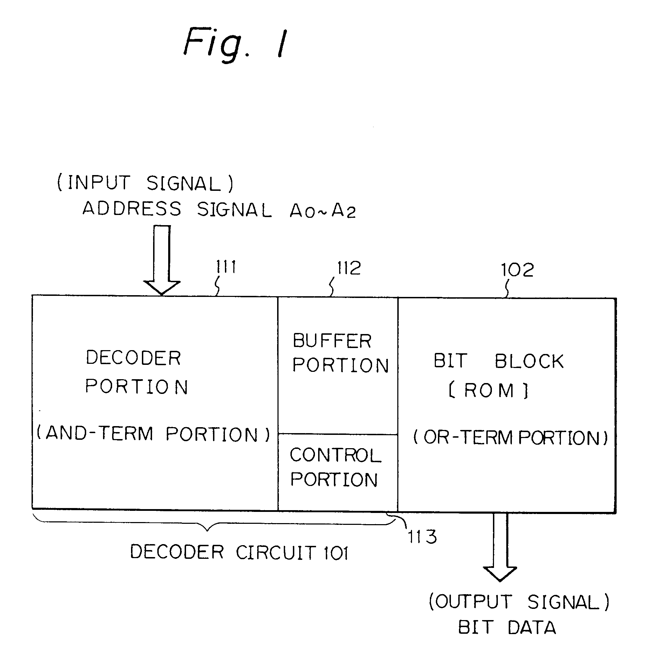

First, an existing decoder circuit applied to a read only memory is explained with reference to Figs. 1, 2, and 3.

Figure 1 is a block diagram showing one example of an existing decoder circuit applied to a read only memory. As shown in Fig. 1, the decoder circuit 101 comprises a decoder portion 111, i.e., an AND-term portion, a buffer portion 112, and a control portion 113. The decoder circuit 101 is connected to a bit block 102, i.e., an OR-term portion, and selects one word line of the OR-term portion in accordance with an address signal of an input signal $A_0$ - $A_2$ , so that a bit data of an output signal is output from the bit block 102.

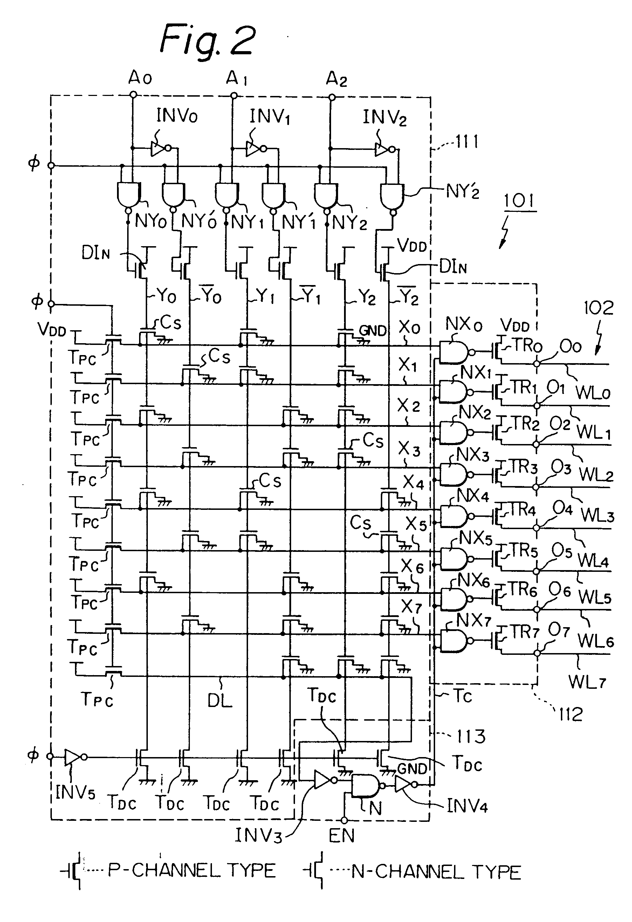

Figure 2 is a circuit diagram showing one example of the decoder circuit as shown in Fig. 1. This decoder circuit 101 is a dynamic type circuit wherein input signal conductors $Y_0$ - $\overline{Y_2}$ are constructed by complemental signal conductors such as a pair of $Y_0$ and $\overline{Y_0}$ , a pair of $Y_1$ and $Y_1$ , and a pair of $Y_2$ and $\overline{Y_2}$. Output signal conductors $X_0$ - $X_7$ are provided so as to cross the input signal conductors $Y_0$ - $\overline{Y_2}$. A cell transistor Cs is provided for each crossed portion of the input signal conductors $Y_0$ - $Y_2$ and the output signal conductors $X_0$ - $X_7$ , and one of the output signal conductors is selected in accordance with a decoded logic of the contents of the input signals $A_0$ - $A_2$. Note, each cell transistor Cs is formed by an N-channel MIS transistor.

In the decoder portion 111, input portions of the input signal conductors $Y_0$ - $\overline{Y_2}$ are provided with NAND circuits $NY_0$ - $NY_2'$ to which input signals $A_0$ - $A_2$ , inverted signals $\overline{A_0}$ - $\overline{A_2}$ , of the input signals $A_0$ - $A_2$ , and a clock signal $\phi$ are applied. Namely, one input terminal of the NAND circuits $NY_0$ , $NY_1$ , and $NY_2$ is supplied with the input signals $A_0$ , $A_1$ , and $A_2$ , respectively, one input terminal of the NAND circuits $NY_0'$, $NY_1'$ and $NY_2'$ is supplied with the inverted input signals $\overline{A_0}$ , $\overline{A_1}$ , and $\overline{A_2}$ inverted by inverter circuits $INV_0$ , $INV_1$ , and $INV_2$ respectively, and the other input terminals of the all of the NAND circuits $NY_0$ - $NY_2'$ are supplied with the clock signal $\phi$. An output terminal of each of the NAND circuits $NY_0$ - $NY_2'$ is connected to the corresponding input signal conductors $Y_0$ - $\overline{Y_2}$ through each of drive transistors $D_{IN}$ which are P-channel type MIS transistors, respectively.

In the buffer portion 112, output portions of the output signal conductors $X_0$ - $X_7$ are provided with NAND circuits $NX_0$ - $NX_7$ , and one input terminal of each of the NAND circuits $NX_0$ - $NX_7$ is connected to one of the output signal conductors $X_0$ - $X_7$. The other input terminal of each of the NAND circuits $NX_0$ - $NX_7$ is supplied with a timing signal Tc after changing a potential of the output signal conductors, except one selected output signal conductor, to a low level. Namely, the timing signal Tc is used to avoid a selection error, and this timing signal is output from a control circuit 113 in the decoder circuit 101.

The control circuit 113 comprises an inverter $INV_3$ having an input supplied with a potential of a dummy signal conductor DL wired in the same manner as the output signal conductance $X_0$ - $X_7$ , a NAND circuit N, and an inverter $INV_4$.

The other sides of the input signal conductors $Y_0$ - $\overline{Y_2}$ are provided with discharge transistors $T_{DC}$ which are switched ON while the clock signal $\phi$ is at a low level. These transistors are N-channel type MIS transistors, and gate electrodes thereof are supplied with an inverted clock signal $\phi$ by an inverter $IV_5$.

The other sides of the output signal conductors $X_0$ - $X_7$ are provided with precharge transistors Tpc which are driven by the clock signal $\phi$. The precharge transistors Tpc, which are P-channel type MIS transistors, are switched ON when the clock signal $\phi$ is at a high level, and the output signal conductors $X_0$ - $X_7$ and the dummy signal conductor DL are precharged to a power source potential $V_{DD}$.

The output terminals of the NAND circuits $NX_0$ - $NX_7$ are connected to gate electrodes of the output transistors $TR_0$ - $TR_7$ (P-channel type MIS transistors), respectively. Note, the drain electrodes of the output transistors $TR_0$ - $TR_7$ serve as output terminals $O_0$ - $O_7$ in this decoder circuit 101, and are connected, for example, to a cell array of the ROM 102 through word lines $WD_0$ - $WD_7$.

The above described decoder circuit is formed by a C-MIS circuit, as shown in Fig. 2, wherein transistors shown by a thick line are P-channel type MIS (P-MIS) transistors and a transistor shown by a normal line is an N-channel type MIS (N-MIS) transistor, Note, an N-MIS transistor is switched ON when an input signal thereof is at a high level, and a P-MIS transistor is switched ON when an input signal thereof is at a low level.

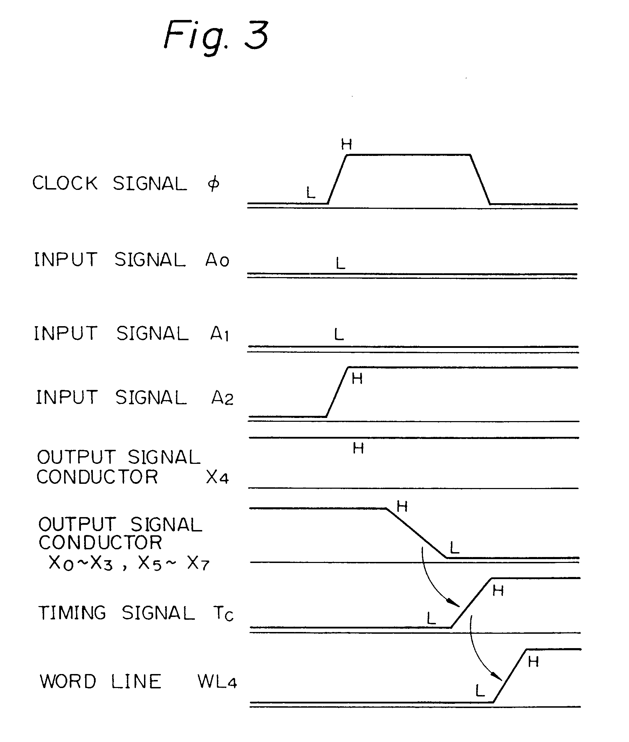

Next, the operation of the above circuit is explained with reference to Fig. 3.

A period during which the clock signal $\phi$ is at a low level corresponds to a reset period of the decoder circuit 101, and a period during which the clock signal $\phi$ is at a high level corresponds to an active period of the decoder circuit 101.

First, in the period during which the clock signal $\phi$ is at a low level, the precharge transistors Tpc and the discharge transistors $T_{DC}$ are switched ON, all of the input signal conductors $Y_0$ - $\overline{Y_2}$ are discharged, and all of the output signal conductors $X_0$ - $X_7$ are precharged. In this case, all output signals of the NAND circuits $NY_0$ - $NY_2'$ are at a high level, and thus all of the input transistors $D_{IN}$ are switched OFF. When the clock signal $\phi$ goes from the low level to a high level, all of the precharge transistors Tpc and all of the discharge transistors $T_{DC}$ are switched OFF, and the input signal conductors $Y_0$ - $\overline{Y_2}$ are at a high level or a low level in accordance with address signals (input signals) $A_0$ , $A_1$ , and $A_2$. As a result, one of the output signal conductors $X_0$ - $X_7$ is maintained at the precharged level, and the other output signal conductors are discharged through the cell transistors Cs.

For example, when the input signal $A_0$ is at a low level, $A_1$ is at a low level and $A_2$ is at a high level, the input signal conductors $Y_0$ , $Y_1$ , and $\overline{Y_2}$ are brought to a low level, and the other signal conductors are brought to a high level. Consequently, only one output signal conductor $X_4$ is selected by the above potential relationship of the input signals $A_0$ , $A_1$ and $A_2$ and a connection relationship of the cell transistors Cs. In this case, a potential of the selected output signal conductor $X_4$ is maintained at the high level, and the other output signal conductors $X_0$ - $X_3$ and $X_5$ - $X_7$ are discharged and brought to a low level by each corresponding cell transistor Cs. Next, the timing signal Tc (high level) is input to the NAND circuits $NX_0$ - $NX_7$ , after all of the unselected output signal conductors $X_0$ - $X_3$ and $X_5$ - $X_7$ are discharged, and thus an input of only the NAND circuit $NX_4$ corresponding to the selected output signal conductor $X_4$ is brought to a high level and a low level signal is output to an output transistor $TR_4$. Consequently, only the output transistor $TR_4$ is switched ON, and a word line $WL_4$ is driven.

The timing for generating the timing signal Tc is determined by a discharge time of the dummy signal conductor DL. Namely, the dummy signal conductor DL has the longest discharge time (or longer than the longest discharge time) among the output signal conductors $X_0$ - $X_7$. Note, the dummy signal conductor DL is not selected (i.e., is always discharged) regardless of the address signals $A_0$ - $A_2$. As a result a potential of the dummy signal conductor DL is always changed to a low level in a decoding operation, when an output signal conductor is selected. In the control portion 113, this signal of the dummy signal conductor DL is applied to an input of the inverter $IV_3$ , and when the other input of a NAND circuit N is supplied with a high level enable signal EN from another circuit (not shown in the drawing) a high level timing signal Tc is output from an inverter $IV_4$. As described above, the timing signal Tc must be output after it is confirmed that all of the unselected output signal conductors $X_0$ - $X_3$ and $X_5$ - $X_7$ are fully discharged, since an error may be generated such that a plurality of output signal conductors are selected when the timing signal Tc is applied before the discharge operation described above is completed.

As described above, this type of decoder circuit 101 has problems in that the timing signal Tc should be applied to the NAND circuits and the word lines must be driven by the timing signal Tc through the NAND circuits $NX_0$ - $NX_7$. Namely, as understood from Fig. 3, the timing signal Tc must be generated after the all of the nonselected output signal conductors $X_0$ - $X_3$ and $X_5$ - $X_7$ are fully discharged. Therefore, an output timing of the timing signal Tc must include a time margin, taking into consideration a discharge time for fully discharging an electrical charge in each of the output signal conductors $X_0$ - $X_7$ , and thus the drive timing of the word line $WL_4$ corresponding to the selected output signal conductor $X_4$ is delayed and hinders a high speed operation of the decoder circuit.

Further, in the decoder circuit 101, the NAND circuits $NX_0$ - $NX_7$ of the buffer portion 112 and the control portion 113 including the inverter $INV_3$ , the NAND circuit N, and the inverter $INV_4$ must be provided and thus the construction of the decoder circuit becomes complicated. Furthermore, when C-MIS transistors are used, a NAND circuit is formed by four transistors, and thus a problem arises in a pattern layout of the decoder circuit, when the decoder circuit is used by a large scale integration circuit. Namely, when the four transistors of the NAND circuit are provided in parallel with the input signal conductors, a large space is occupied by these four transistors, but if the four transistors of the NAND circuit are provided in series, the wiring process for connecting these four transistors must be carried out. Therefore, a problem arises whenever a large a number of transistors is used for the NAND circuit. For example, when used as an address decoder of a ROM, the scale of the decoder circuit as a peripheral circuit is too large to realize the purpose of making a memory cell small, and thus it is difficult to insert the buffer portion in a small space between two adjacent signal conductors or between each pitch of neighboring word lines.

The present invention may provide a decoder circuit having a simple configuration, a high speed and stable operation, and suitable for application to a large scale integration circuit.

Below, an embodiment of the present invention will be explained with reference to the drawings.

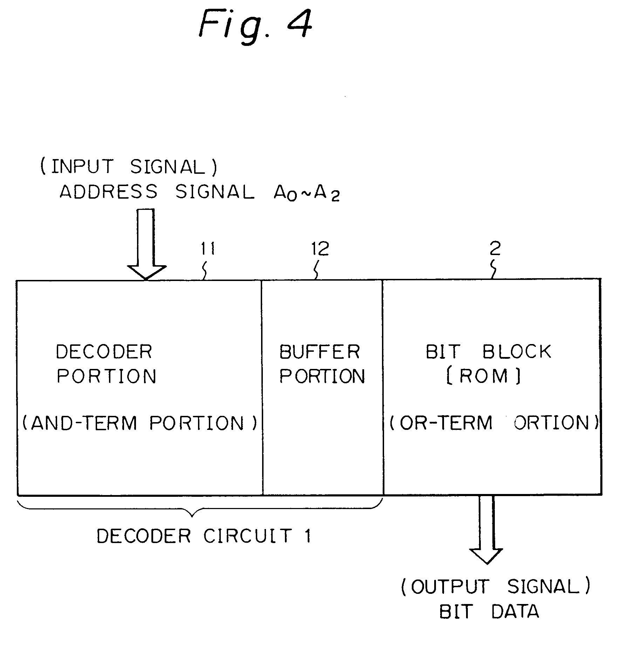

Figure 4 is a block diagram showing one embodiment of a decoder circuit according to the present invention. As shown in Fig. 4, the decoder circuit 1 comprises a decoder portion 11, i.e., an AND-term portion, and a buffer portion 12. Namely, the control portion of the existing type decoder circuit is not needed for the present embodiment. The decoder circuit 1 is connected to a bit block 2, i.e., an OR-term portion, and selects one word line of the OR-term portion in accordance with an address signal of an input signal $A_0$ - $A_2$ , whereby bit data of an output signal is output from the bit block 2.

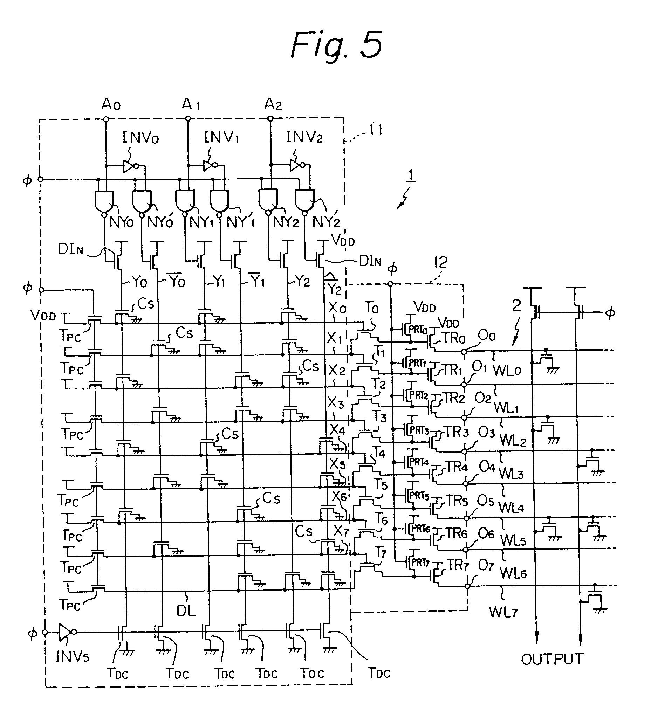

A circuit diagram of the embodiment according to the present invention is shown in Fig. 5. In this embodiment, the same portions as shown in the existing type decoder circuit of Fig. 2 are indicated by the same references. In this decoder circuit 1, input signal conductors $Y_0$ - $\overline{Y_2}$ are complemental signal conductors such as a pair of $Y_0$ and $\overline{Y_0}$ , a pair of $Y_1$ and $\overline{Y_1}$ , and a pair of $Y_2$ and $\overline{Y_2}$. Output signal conductors $X_0$ - $X_7$ are provided so as to cross the input signal conductors $Y_0$ - $\overline{Y_2}$. A cell transistor Cs is provided for each crossed portion of the input signal conductors $Y_0$ - $\overline{Y_2}$ and the output signal conductors $X_0$ - $X_7$ , and one of the output signal conductors is selected in accordance with a decoded logic of the contents of the input signals $A_0$ - $A_2$. Note, each cell transistor Cs is formed by an N-channel MIS transistor.

In the decoder portion 11, input portions of the input signal conductors $Y_0$ - $\overline{Y_2}$ are provided with NAND circuits $NY_0$ - $NY_2'$ to which input signals $A_0$ - $A_2$ , inverted signals $\overline{A_0}$ - $\overline{A_2}$ of the input signals $A_0$ - $A_2$ , and a clock signal $\phi$ are applied. Namely, each input terminal of the NAND circuits $NY_0$ , $NY_1$ and $NY_2$ is supplied with the input signals $A_0$ , $A_1$ , and $A_2$ , each input terminal of the NAND circuits $NY_0'$, $NY_1'$ and $NY_2'$ is supplied with the inverted input signals $\overline{A_0}$ , $\overline{A_1}$ and $\overline{A_2}$ inverted by inverter circuits $INV_0$ , $INV_1$ and $INV_2$ , and the other input terminals of all of the NAND circuits $NY_0$ - $NY_2'$ are supplied with the clock signal $\phi$. An output terminal of each of the NAND circuits $NY_0$ - $NY_2'$ is connected to the corresponding input signal conductors $Y_0$ - $\overline{Y_2}$ through each of drive transistors $D_{IN}$ which are P-channel type MIS transistors, respectively.

In the above description, the decoder portion 11 of the decoder circuit 1 of the present embodiment has the same configuration as the existing circuit, but in the present embodiment, the configuration of the buffer portion 12 is simpler than that of the existing buffer portion, the present decoder circuit has a high speed and stable operation, and the present embodiment does not need the control portion necessary in the existing decoder circuit.

As shown in Fig. 5, in the buffer portion 12, an output end of each of the output signal conductors $X_0$ - $X_7$ is connected to a gate electrode of a corresponding transfer transistor $T_0$ - $T_7$ provided for each of the output signal conductors $X_0$ - $X_7$ , and a source electrode of each of the transfer

transistors $T_0$ - $T_7$ is connected to a neighboring output signal conductor thereof. For example, in a transfer transistor $T_0$ , a gate electrode of the transfer transistor $T_0$ is connected to a corresponding output signal conductor $X_0$ , and a source electrode thereof is connected to a neighboring output signal conductor $X_1$. Similarly, in a transfer transistor $T_1$ , a gate electrode of the transfer transistor $T_1$ is connected to a corresponding output signal conductor $X_1$ , and a source electrode thereof is connected to a neighboring output signal conductor $X_2$. Note, a dummy signal conductor DL is discharged to a low level regardless of the address signals $A_0$ - $A_2$ , during a decoder operation, and thus the dummy signal conductor DL can be connected to a source electrode of a transfer transistor $T_7$.

A drain electrode of each of the transfer transistors $T_0$ - $T_7$ is connected to a gate electrode of each corresponding output transistor $TR_0$ - $TR_7$ and a drain electrode of each corresponding preset transistor $PRT_0$ - $PRT_7$ , respectively. Namely, a drain electrode of the transfer transistor $T_0$ is connected to a gate electrode of a output transistor $TR_0$ and a drain electrode of a preset transistor $PRT_0$ , and a drain electrode of the transfer transistor $T_1$ is connected to a gate electrode of a output transistor $TR_1$ and a drain electrode of a preset transistor $PRT_1$. A source electrode of each preset transistor $PRT_0$ - $PRT_7$ and a source electrode of each output transistor $TR_0$ - $TR_7$ are supplied with a power supply potential $V_{DD}$. A drain electrode of each output transistor $TR_0$ - $TR_7$ is connected to each corresponding output terminal $O_0$ - $O_7$. Note, in the buffer portion 12 of the decoder circuit 1, only three transistors, i.e., a transfer transistor $T_0$ - $T_7$ , a preset transistor $PRT_0$ - $PRT_7$ and an output transistor $TR_0$ - $TR_7$ , are needed, and thus these three transistors can be provided in a small space between two adjacent signal conductors. Namely, a space between two adjacent signal conductors or each pitch of neighboring word lines is made smaller. Note, the transfer transistors $T_0$ - $T_7$ are N-channel type MIS transistors, and the preset transistors $PRT_0$ - $PRT_7$ and the output transistors $TR_0$ - $TR_7$ are P-channel type MIS transistors. Further, the output terminals $O_0$ - $O_7$ are connected to word lines $WL_0$ - $WL_7$ of the bit block 2. The bit block 2 is, for example, a read only memory having a plurality of word lines ($WL_1$ - $WL_7$), a plurality of bit lines and a plurality of memory cells.

The other sides of the input signal conductors $Y_0$ - $\overline{Y_2}$ are provided with discharge transistors $T_{DC}$ which are switched ON while the clock signal $\phi$ is at a low level. These transistors are N-channel type MIS transistors, and the gate electrodes thereof are supplied with an inverted clock signal $\phi$ by an inverter $IV_5$.

The other sides of the output signal conductors $X_0$ - $X_7$ are provided with precharge transistors Tpc driven by the clock signal $\phi$. The precharge transistors Tpc, which are P-channel type MIS transistors, are switched ON when the clock signal $\phi$ is at a low level, and the output signal conductors $X_0$ - $X_7$ and the dummy signal conductor DL are precharged at a high level.

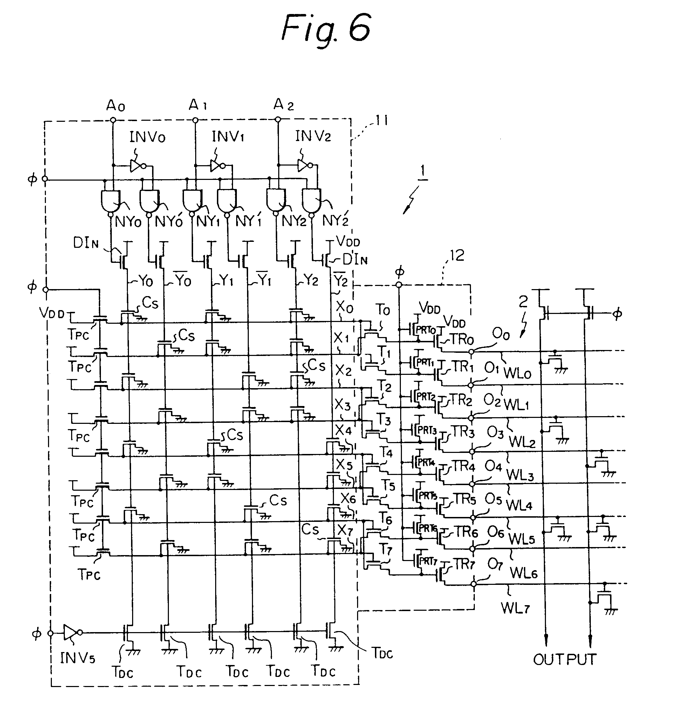

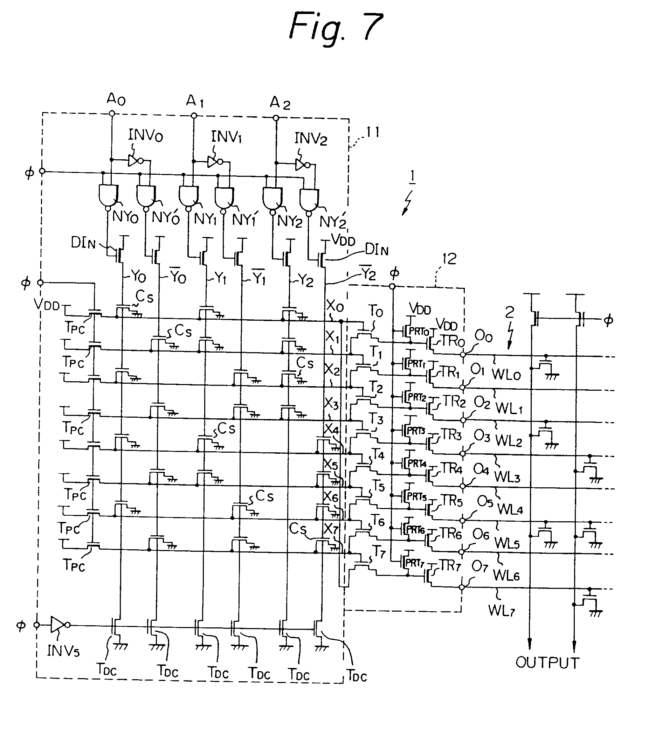

Figures 6 and 7 are circuit diagrams showing modifications of the embodiment of the decoder circuit shown in Fig. 5. In these decoder circuits, the dummy signal conductor DL can be omitted.

As shown in Fig. 6, in one modification of the decoder circuit, output signal conductors $X_0$ - $X_7$ are divided into pairs of two adjacent output signal conductors, a gate electrode of one transfer transistor of each pair is connected to one output signal conductor and a gate electrode of the other transfer transistor is connected to the other output signal conductor, and a source electrode of one transfer transistor is connected to the other output signal conductor and a source electrode of the other transfer transistor is connected to one output signal conductor, respectively. For example, in a pair of two adjacent output signal conductors $X_0$ and $X_1$ , a gate electrode of a transfer transistor $T_0$ is connected to the output signal conductors $X_0$ and a source electrode of the transfer transistor $T_0$ is connected to the output signal conductors $X_1$, and a gate electrode of a transfer transistor $T_1$ is connected to the output signal conductors $X_1$ and a source electrode of the transfer transistor $T_1$ is connected to the output signal conductors $X_0$. Similarly, for example, in a pair of two adjacent output signal conductors $X_2$ and $X_3$ , a gate electrode of a transfer transistor $T_2$ is connected to the output signal conductors $X_2$ and a source electrode of the transfer transistor $T_2$ is connected to the output signal conductors $X_3$ , and a gate electrode of a transfer transistor $T_3$ is connected to the output signal conductors $X_3$ and a source electrode of the transfer transistor $T_3$ is connected to the output signal conductors $X_2$.

In another modification of the decoder circuit shown in Fig. 7, each of the output signal conductors $X_0$ - $X_7$ is connected to a gate electrode of each corresponding transfer transistor $T_0$ - $T_7$ , a source electrode of each transfer transistor $T_0$ - $T_6$ , except a last transfer transistor $T_7$ , is connected to an adjacent output signal conductor $X_1$ - $X_7$ , except a first signal conductor $X_0$. A source electrode of the last transfer transistor $T_7$ is connected to the first output signal conductor $X_0$.

As described above, in these modifications of the decoder circuit, the dummy signal conductor DL can be omitted. Furthermore, a source electrode of each of the transfer transistors $T_0$ - $T_7$ is not only connected to an djacent output signal conductor $X_1$ - $X_7$ and DL, which are connected to the gate electrode of the each of the transfer transistors $T_0$ - $T_7$ , but also the source electrode of each of the transfer transistors $T_0$ - $T_7$ can be connected to any one of the other signal conductors $X_0$ - $X_7$ and DL without connecting to a gate electrode thereof. Namely, for example, in a transfer transistor $T_0$ , a gate electrode of the transfer transistor $T_0$ is connected to a corresponding output signal conductor $X_0$ , and a source electrode thereof can be connected to another signal conductor $X_1, X_2$ , $X_3$ , $X_4$ , $X_5$ , $X_5$ , $X_7$ or DL. Similarly, in a transfer transistor $T_1$ , a gate electrode of the transfer transistor $T_1$ is connected to a corresponding output signal conductor $X_1$ , and a source electrode thereof can be connected to another signal conductor $X_0$ , $X_2$ , $X_3$ , $X_4$ , $X_5$ , $X_5$ , $X_7$ or DL.

The above described decoder circuits are formed by a C-MIS circuit, and as shown in Figs. 5, 6, and 7, transistors drawn by a thick line are P-channel type MIS (P-MIS) transistors and a transistor shown by a normal line is an N-channel type MIS (N-MIS) transistor.

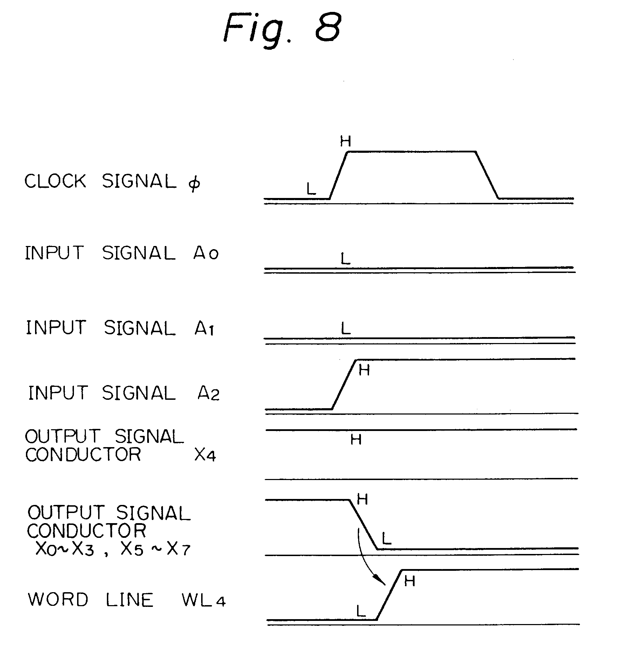

Next, an operation of the embodiment of the decoder circuit as shown in Fig. 5 is explained with reference to Fig. 8.

In this embodiment, only one transfer transistor (one of the select transistors $T_0$ - $T_7$) having a gate electrode connected to the selected output signal conductor, which is at a high level, is switched ON. The other transfer transistors having gate electrodes connected to the other non selected signal conductors are not switched ON, since both the gate electrodes and source electrodes thereof are at a low level. The above operations are a principle of the present embodiment, and detailed explanation of these operations is given below.

First, in a decoder circuit, each node thereof is set to a specific potential in synchronization with a clock signal $\phi$, when the clock signal $\phi$ is at a low level. Namely, when the clock signal $\phi$ is at a low level, a gate electrode of each of the present transistors $PRT_0$ - $PRT_7$ , which are P-channel type MIS transistors, is at a low level, and then all of the preset transistors $PRT_0$ - $PRT_7$ are switched ON, whereby a gate potential of each of the output transistors $TR_0$ -$PR_7$ is precharged to a high level state.

Further, at the same time, all of the precharge transistors Tpc and the discharge transistors $T_{DC}$ are switched ON, each input signal conductor $Y_0$ - $\overline{Y_2}$ is discharged to a low level, and each output signal conductor $X_0$ - $X_7$ is precharged to a high level.

When the clock signal $\phi$ is made high level and address signals $A_0$ - $A_3$ are supplied will be explained. To simplify the explanation, the logical states of the address signals $A_0$ , $A_1$ and $A_3$ are

assumed to be the same as in Fig. 3, i.e., the address signals $A_0$ is at a low level, $A_1$ is at a low level, and $A_3$ is at a high level. In this state of the address signals $A_0$ - $A_3$, similar to the example in Fig. 2, an output signal conductor $X_4$ is selected by NAND circuits $NY_0$ - $NY_2$, inverter circuits $INV_0$ - $INV_2$, drive transistors $D_{IN}$, and a cell transistor Cs. In this case, a potential of the output signal conductor $X_4$ is maintained at a high level, since all of the cell transistors connected to the output signal conductor $X_4$ are kept OFF. The potential levels of the other non selected output signal conductors $X_0$ - $X_3$ and $X_5$ - $X_7$ are made low level. Note, a potential level of the dummy signal conductor is also made low level.

As a result, a gate potential of the transfer transistor $T_4$ is kept at a high level, a source potential thereof is made low level, and the only one transfer transistor $T_4$ is switched ON, since a voltage between the gate electrode and the source electrode is higher than a threshold voltage thereof.

On the other hand, a transfer transistor $T_3$ is kept OFF, since a source potential thereof is at a high level, a gate potential thereof is made low level, and a reverse bias is applied between the gate electrode and the source electrode thereof. The other transfer transistors $T_0$, $T_1$, $T_2$, $T_5$, $T_6$ and $T_7$ are kept OFF, since both a gate potential and a source potential thereof are made low level. Note, in the other transfer transistors $T_0$, $T_1$, $T_2$, $T_5$, $T_6$ and $T_7$, the gate potential thereof is made the same as the source potential thereof. Namely, when the transfer transistor $T_4$ is switched ON and the other transfer transistors $T_0$ - $T_3$ and $T_5$ - $T_7$ are switched OFF, the relationship between a gate potential and a source potential of each of the other transfer transistors $T_0$ - $T_3$ and $T_5$ - $T_7$ is such that the gate potential is gradually made low level, and at the same time, the source potential is made low level. Even if an environmental condition of the decoder circuit such as an ambient temperature is changed, the gate potential and the source potential of each transfer transistor $T_0$, $T_1$, $T_2$, $T_5$, $T_6$ and $T_7$ are made equivalent to each other, and thus each transfer transistors $T_0$, $T_1$, $T_2$, $T_5$, $T_6$ and $T_7$ is made OFF, respectively. Consequently, the gate potential is not higher than the source potential, and thus an OFF state is maintained and a selection error can not be made.

When the transfer transistor $T_4$ is switched ON, a gate electric charge of the output transistor $TR_4$ is discharged by a source electrode of the transfer transistor $T_4$ connected to an adjacent output signal conductor $X_5$, whereby a gate potential of the output transistor $TR_4$ is made low level. Therefore, the output transistor $TR_4$ is switched ON, and the word line $WL_4$ is made high level.

Note, in the present invention, the transistors of the decoder circuit can have a reverse polarity to those of the above embodiment. In this case, a P-channel MIS transistor is replaced by an N-channel MIS transistor, an N-channel MIS transistor is replaced by a P-channel MIS transistor, a logical value is reversed, an operation of each preset transistor $PRT_0$ - PRT is used for discharging, and an operation of each transfer transistor $T_0$ - $T_7$ is used for charging.

As described above, in accordance with the present invention, only one output signal conductor is selected during a period of decode operation in which a timing signal is not used a control circuit for outputting the timing signal is not required. Therefore, unnecessary delay is avoided and operation errors do not occur. Furthermore, since NAND circuits are not needed for the buffer portion of the present invention, the circuit is simpler and thus suitable for a large scale integration circuit.

Many widely different embodiments of the present invention may be constructed without departing from the scope of the present invention, and it should be understood that the present invention is not limited to the specific embodiments described in this specification, except as defined in the appended claims.

## Claims

1. A decoder circuit including a plurality of signal conductors ($X_0$ - $X_7$, DL), a first potential setting means (Tpc) connected to said signal conductors ($X_0$ - $X_7$, DL) and operable to set a potential of said signal conductors ($X_0$ - $X_7$, DL) at a first potential, and a second potential setting means (Cs) connected to said signal conductors ($X_0$ - $X_7$, DL) and operable to maintain a potential of one of said signal conductors ($X_0$ - $X_7$) at said first potential and to reduce a potential of remaining said signal conductors ($X_0$ - $X_7$, DL) to a second potential, characterized in that said decoder circuit comprises:

a respective transfer transistor ($T_0$ -$T_7$) provided for each signal conductor ($X_1$ - $X_7$), a gate electrode of each transfer transistor ($T_0$ - $T_7$) being connected to the corresponding signal conductor ($X_0$ - $X_7$), a source electrode thereof being connected to another signal conductor (X1 - $X_7$, DL), whereby in use, one of said transfer transistors ($T_0$ - $T_7$) is switched ON and a decoded output signal is output when a gate potential of that transfer transistor ($T_0$ - $T_7$) is maintained at said first potential and a source potential thereof is brought to said second potential.

2. A decoder circuit according to claim 1, wherein said plurality of signal conductors ($X_0$ - $X_7$, DL) comprises a plurality of output signal conductors ($X_0$ - $X_7$) and a dummy signal conductor (DL).

3. A decoder circuit according to claim 1 or 2, wherein said first potential setting means (Tpc) comprises a plurality of precharge transistors, each precharge transistor (Tpc) being connected to a respective said signal conductor ($X_0$ - $X_7$, DL).

4. A decoder circuit according to claim 3, wherein a source electrode of each precharge transistor (Tpc) is supplied with a first power supply potential ($V_{DD}$), a gate electrode thereof is supplied with a clock signal ($\phi$), and a drain electrode thereof is connected to the respective said signal conductor ($X_0$ - $X_7$, DL).

5. A decoder circuit according to claim 1, 2, 3 or 4, wherein said second potential setting means (Cs) comprises a plurality of cell transistors, each cell transistor (Cs) being connected to a respective said signal conductor ($X_0$ - $X_7$, DL) and operable to select that signal conductor ($X_0$ - $X_7$) in accordance with input signals ($A_0$ - $A_3$).

6. A decoder circuit according to claim 5, wherein a source electrode of each cell transistor (Cs) is connected to one of said signal conductors ($X_0$ - $X_7$, DL), a gate electrode thereof is connected to one of a plurality of input signal conductors ($Y_0$ - $\overline{Y_2}$), and a drain electrode thereof is arranged to be supplied with a second power supply potential (GND), wherein, in use, a potential of one signal conductor ($X_0$ - $X_7$) is maintained at said first potential and a potential of the remaining signal conductors ($X_0$ - $X_7$, DL) is brought to said second potential through said cell transistors (Cs).

7. A decoder circuit according to claim 6, wherein one end of each input signal conductor ($Y_0$ - $\overline{Y_2}$) is connected to a respective drive transistor ($D_{IN}$), and the other end of each input signal conductor ($Y_0$ - $\overline{Y_2}$) is connected to a respective discharge transistor ($T_{DC}$), said drive transistors ($D_{IN}$) being controlled by said input signals ($A_0$ - $A_3$) and said clock signal ($\phi$) through corresponding NAND-gate circuits ($NY_0$ - $NY_2'$) and inverter circuits (INV0 - INV2), and said discharge transistors ($T_{DC}$) being controlled by said clock signal through an inverter circuit ($INV_5$).

8. A decoder circuit according to any preceding claim, wherein the source electrode of each transfer transistor ($T_0$ - $T_7$) is connected to a said signal conductor ($X_2$ - $X_7$, DL) adjacent to a said signal conductor ($X_0$ - $X_7$) connected to the gate electrode of that transfer transistor ($T_0$ - $T_7$).

9. A decoder circuit according to claim 8, wherein the source electrode of a last transfer transistor ($T_7$) is connected to said dummy signal conductor (DL).

10. A decoder circuit according to claim 8, wherein the source electrode of a last transfer transistor ($T_7$) is connected to the first signal conductor ($X_0$).

11. A decoder circuit according to claim 8, wherein said signal conductors ($X_0$ - $X_7$) are divided into pairs of first and second adjacent output signal conductors ($X_0$, $X_1$; $X_2$, $X_3$; $X_4$, $X_5$; $X_5$, $X_7$), connected to gate electrodes of first and second transfer transistors ($T_0$, $T_1$; $T_2$, $T_3$; $T_4$, $T_5$; $T_6$, $T_7$), a source of the first transfer transistor ($T_0$; $T_2$; $T_4$; $T_6$) is connected to said second output signal conductor ($X_1$; $X_3$; $X_5$; $X_7$), and a source of the second transfer transistor ($T_1$; $T_3$; $T_5$; $T_7$) is connected to said first output signal conductor ($X_0$; $X_2$; $X_4$; $X_5$), respectively.

12. A decoder circuit according to any preceding claim, wherein a drain electrode of each transfer transistor ($T_0$ - $T_7$) is connected to a drain electrode of a respective preset transistor ($PRT_0$ - $PRT_7$) and to a gate electrode of a respective output transistor ($TR_0$ - $TR_7$), a source electrode of each preset transistor ($PRT_0$ - $PRT_7$) is supplied with said first power supply potential ($V_{DD}$) and a gate electrode of each preset transistor ($PRT_0$ - $PRT_7$) is supplied with said clock signal ($\phi$), and a source electrode of each output transistor ($TR_0$ - $TR_7$) is supplied with said first power supply potential ($V_{DD}$) and a drain electrode of each output transistor ($TR_0$ - $TR_7$) is connected to a respective output terminal ($O_0$ - $O_7$).

13. A decoder circuit according to claim 12, wherein each transfer transistor ($T_0$ - $T_7$), preset transistor ($PRT_0$ - $PRT_7$) and output transistor ($TR_0$ - $TR_7$) is disposed in a space between adjacent ones of said signal conductors ($X_0$ - $X_7$, DL).

14. A decoder circuit according to any preceding claim, wherein all of said transistors are MIS type transistors.

15. A decoder circuit according to claim 14, wherein said first potential setting means (Tpc) comprises a plurality of P-channel type MIS precharge transistors, wherein said second potential setting means comprises a plurality of N-channel type MIS cell transistors, and wherein each transfer transistor ($T_0$ - $T_7$) is an N-channel type MIS transistor.

16. A read only memory device comprising a decoder circuit according to any preceding claim.

**Patentansprüche**

1. Eine Dekodierschaltung, welche eine Vielzahl von Signalleitungen ($X_0$ - $X_7$, DL), ein mit den Signalleitungen ($X_0$ - $X_7$, DL) verbundenes und so betreibbares erstes Potentialeinstellmittel (Tpc), daß es ein Potential der Signalleitungen ($X_0$ - $X_7$, DL) auf ein erstes Potential einstellt, und ein mit den Signalleitungen ($X_0$ - $X_7$, DL) verbundenes und so betreibbares zweites Potentialeinstellmittel (Cs), daß es ein Potential einer der Signalleitungen ($X_0$ - $X_7$) auf dem ersten Potential hält und ein Potential der verbleibenden Signalleitungen ($X_0$ - $X_7$, DL) auf ein zweites Potential reduziert, umfaßt, **dadurch gekennzeichnet, daß** die Dekodierschaltung enthält:

einen entsprechenden Transfertransistor ($T_0$ - $T_7$), der für jede Signalleitung ($X_1$ - $X_7$) vorgesehen ist, wobei eine Gate-Elektrode eines jeden Transfertransistors ($T_0$ - $T_7$) mit der entsprechenden Signalleitung ($X_0$ - $X_7$) verbunden ist, eine Source-Elektrode davon mit einer weiteren Signalleitung ($X_1$ - $X_7$, DL) verbunden ist, und wodurch im Betrieb einer dieser Transfertransistoren ($T_0$ - $T_7$) eingeschaltet ist und ein dekodiertes Ausgangssignal ausgegeben wird, wenn ein Gatepotential jenes Transfertransistors ($T_0$ - $T_7$) auf dem ersten Potential gehalten wird und ein Source-Potential davon auf das zweite Potential gebracht wird.

2. Eine Dekodierschaltung gemäß Anspruch 1, bei welcher die Vielzahl von Signalleitungen ($X_0$ - $X_7$, DL) eine Vielzahl von Ausgangssignalleitungen ($X_0$ - $X_7$) und eine Blindsignalleitung (DL) umfaßt.

3. Eine Dekodierschaltung gemäß Anspruch 1 oder 2, bei welcher das erste Potentialeinstellmittel (Tpc) eine Vielzahl von Vorladetransistoren umfaßt, wobei jeder Vorladetransistor (Tpc) mit einer entsprechenden Signalleitung ($X_0$ - $X_7$, DL) verbunden ist.

4. Eine Dekodierschaltung gemäß Anspruch 3, bei welcher eine Source-Elektrode eines jeden Vorladetransistors (Tpc) mit einem ersten Stromversorgungspotential ($V_{DD}$) gespeist wird, eine Gateelektrode davon mit einem Taktsignal ($\phi$) gespeist wird und eine Drain-Elektrode davon mit der entsprechenden Signalleitung ($X_0$ - $X_7$, DL) verbunden ist.

5. Eine Dekodierschaltung gemäß Anspruch 1, 2, 3 oder 4, bei welcher das zweite Potentialeinstellmittel (Cs) eine Vielzahl von Zelltransistoren umfaßt, wobei jeder Zelltransistor (Cs) mit einer entsprechenden Signalleitung ($X_0$ - $X_7$, DL) verbunden und so betreibbar ist, daß die Signalleitung ($X_0$ - $X_7$) in Übereinstimmung mit den Eingangssignalen ($A_0$ - $A_3$) ausgewählt wird.

6. Eine Dekodierschaltung gemäß Anspruch 5, bei welcher eine Source-Elektrode jedes Zelltransistors (Cs) mit einer der Signalleitungen ($X_0$ - $X_7$, DL) verbunden ist, eine Gateelektrode davon mit einer aus der Vielzahl der Eingangssignalleitungen ($Y_0$ - $\overline{Y_2}$) verbunden ist und eine Drain-Elektrode davon so angeordnet ist, daß sie mit einem zweiten Stromversorgungspotential (GND) gespeist wird, bei der im Betrieb ein Potential einer Signalleitung ($X_0$ - $X_7$) auf dem ersten Potential gehalten wird und ein Potential der übrigen Signalleitungen ($X_0$ - $X_7$, DL) durch die Zelltransistoren (Cs) auf das zweite Potential gebracht wird.

7. Eine Dekodierschaltung gemäß Anspruch 6, bei welcher das eine Ende jeder Eingangssignalleitung ($Y_0$ - $\overline{Y_2}$) mit einem entsprechenden Treibertransistor ($D_{IN}$) verbunden ist und das andere Ende einer jeden Eingangssignalleitung ($Y_0$ - $\overline{Y_2}$) mit einem entsprechenden Entladetransistor ($T_{DC}$) verbunden ist, wobei die Treibertransistoren ($D_{IN}$) durch die Eingangssignale ($A_0$ - $A_3$) gesteuert werden und das Taktsignal ($\phi$) durch korrespondierende NAND-Gate-Schaltungen ($NY_0$ - $NY_2'$) und Inverterschaltungen (INV0 - INV2), und die Entladetransistoren ($T_{DC}$) vom Taktsignal durch eine Inverterschaltung ($INV_5$) gesteuert werden.

8. Eine Dekodierschaltung gemäß irgendeinem der vorangehenden Ansprüche, in welcher die Source-Elektrode eines jeden Transfertransistors ($T_0$ - $T_7$) mit der Signalleitung ($X_2$ - $X_7$, DL) neben der Signalleitung ($X_0$ - $X_7$) verbunden ist, welche mit der Gateelektrode jenes Transfertransistors ($T_0$ - $T_7$) verbunden ist.

9. Eine Dekodierschaltung gemäß Anspruch 8, bei welcher die Source-Elektrode eines letzten Transfertransistors ($T_7$) mit der Blindsignalleitung (DL) verbunden ist.

10. Eine Dekodierschaltung gemäß Anspruch 8, bei welcher die Source-Elektrode eines letzten Transfertransistors ($T_7$) mit der ersten Signalleitung ($X_0$) verbunden ist.

11. Eine Dekodierschaltung gemäß Anspruch 8, bei welcher die Signalleitungen ($X_0$ - $X_7$) in Paare von ersten und zweiten benachbarten Ausgangssignalleitungen ($X_0$ , $X_1$; $X_2$ , $X_3$; $X_4$ , $X_5$; $X_5$ , $X_7$) geteilt sind, die mit den Gateelektroden der ersten und zweiten Transfertransistoren ($T_0$ , $T_1$; $T_2$ , $T_3$; $T_4$ , $T_5$; $T_6$ , $T_7$) verbunden sind, eine Source des ersten Transfertransistors ($T_0$; $T_2$; $T_4$; $T_6$) mit der zweiten Ausgangssignalleitung ($X_1$; $X_3$; $X_5$; $X_7$) verbunden ist und eine Source des zweiten Transfertransistors ($T_1$; $T_3$; $T_5$; $T_7$) mit der ersten Ausgangssignalleitung ($X_0$; $X_2$; $X_4$ bzw. $X_5$) verbunden ist.

12. Eine Dekodierschaltung gemäß irgendeinem der vorangehenden Ansprüche, bei welcher eine Drain-Elektrode eines jeden Transfertransistors ($T_0$ - $T_7$) mit einer Drain-Elektrode eines entsprechenden Voreinstelltransistors ($PRT_0$ - $PRT_7$) und mit einer Gateelektrode eines entsprechenden Ausgangstransistors ($TR_0$ - $TR_7$) verbunden ist, eine Source-Elektrode eines jeden Voreinstelltransistors ($PRT_0$ - $PRT_7$) mit dem ersten Stromversorgungspotential ($V_{DD}$) gespeist wird und eine Gate-Elektrode eines jeden Voreinstelltransistors ($PRT_0$ - $PRT_7$) mit einem Taktsignal ($\phi$) gespeist wird, und eine Source-Elektrode jedes Ausgangstransistors ($TR_0$ - $TR_7$) mit dem ersten Stromversorgungspotential ($V_{DD}$) gespeist wird, und eine Drain-Elektrode eines jeden Ausgangstransistors ($TR_0$ - $TR_7$) mit einer entsprechenden Ausgangsklemme ($O_0$ - $O_7$) verbunden ist.

13. Eine Dekodierschaltung gemäß Anspruch 12, bei der jeder Transfertransistor ($T_0$ - $T_7$), Voreinstelltransistor ($PRT_0$ - $PRT_7$) und Ausgangstransistor ($TR_0$ - $TR_7$) in einem Raum zwischen benachbarten Signalleitungen ($X_0$ - $X_7$, DL) angeordnet ist.

14. Eine Dekodierschaltung gemäß irgendeinem der vorhergehenden Ansprüche, bei welcher alle Transistoren Transistoren des MIS-Typs sind.

15. Eine Dekodierschaltung gemäß Anspruch 14, bei der das erste Potentialeinstellmittel (Tpc) eine Vielzahl von MIS-Vorladetransistoren des P-Kanal-Typs umfaßt, bei der das zweite Potentialeinstellmittel eine Vielzahl von MIS-Zelltransistoren des N-Kanal-Typs umfaßt und bei der jeder Transfertransistor ($T_0$ - $T_7$) ein MIS-Transistor des N-Kanal-Typs ist.

16. Eine Nur-Lese-Speicher-Einrichtung mit einer Dekodierschaltung gemäß irgendeinem der vorangehenden Ansprüche.

## Revendications

1. Circuit décodeur comportant une pluralité de conducteurs de signaux ($X_0$ - $X_7$, DL), un Premier dispositif de réglage du potentiel (Tpc) relié auxdits conducteurs de signaux ($X_0$ - $X_7$, DL) et utilisable pour régler le potentiel desdits conducteurs de signaux ($X_0$ - $X_7$, DL) à un premier niveau de potentiel, et un second dispositif de réglage du potentiel (Cs) relié audit conducteurs de signaux ($X_0$ - $X_7$, DL) et utilisable pour maintenir le potentiel d'un desdits conducteurs de signaux ($X_0$ - $X_7$) audit premier niveau de potentiel et pour diminuer le potentiel desdits conducteurs de signaux restants ($X_0$ - $X_7$, DL) à un second niveau de potentiel, caractérisé en ce que ledit circuit décodeur comprend:

un transistor de transfert respectif ($T_0$ - $T_7$) fourni pour chaque conducteur de signaux ($X_1$ - $X_7$), l'électrode de grille de chaque transistor de transfert ($T_0$ - $T_7$) étant reliée au conducteur de signaux correspondant ($X_0$ - $X_7$), l'électrode de la source de celui-ci étant reliée à un autre conducteur de signaux ($X_1$ - $X_7$, DL), grâce auquel lors de l'utilisation, un desdits transistors de transfert ($T_0$ - $T_7$) est conducteur et un signal de sortie décodé est fourni lorsqu'on maintient le potentiel de grille de ce transistor de transfert ($T_0$ - $T_7$) au niveau dudit premier potentiel et lorsqu'on porte le potentiel de la source de celui-ci au niveau dudit second niveau de potentiel.

2. Circuit décodeur selon la revendication 1, dans lequel ladite pluralité de conducteurs de signaux ($X_0$ - $X_7$, DL) comprend une pluralité de conducteurs de signaux de sortie ($X_0$ - $X_7$) et un conducteur de signaux fictif (DL).

3. Circuit décodeur selon la revendication 1 ou 2, dans lequel ledit premier dispositif de réglage de potentiel (Tpc) comprend une pluralité de transistors de précharge, chaque transistor de précharge (Tpc) étant relié audit conducteur de

signaux respectif ($X_0$ - $X_7$, DL).

**4.** Circuit décodeur selon la revendication 3, dans lequel l'électrode de la source de chaque transistor de précharge (Tpc) reçoit un premier potentiel d'alimentation ($V_{DD}$), l'électrode de la grille de celuici reçoit un signal d'horloge ($\phi$), et on relie l'électrode du drain de celui-ci audit conducteur de signaux respectif ($X_0$ - $X_7$, DL).

**5.** Circuit décodeur selon la revendication 1, 2, 3 ou 4 dans lequel ledit second dispositif de réglage de potentiel (Cs) comprend une pluralité de transistors élémentaires, chaque transistor élémentaire (Cs) étant relié audit conducteur de signaux respectif ($X_0$ - $X_7$, DL) et utilisable pour sélectionner ce conducteur de signaux ($X_0$ - $X_7$) en fonction des signaux d'entrée ($A_0$ - $A_3$).

**6.** Circuit décodeur selon la revendication 5, dans lequel on relie l'électrode de la source de chaque transistor élémentaire (Cs) à un desdits conducteurs de signaux ($X_0$ - $X_7$, DL), on relie l'électrode de la grille de celui-ci à l'un des conducteurs de signaux d'entrée d'une pluralité de conducteurs ($Y_0$ - $\overline{Y_2}$), et on dispose l'électrode du drain de celui-ci pour recevoir un second niveau de potentiel d'alimentation (GND), grâce auquel, lors de l'utilisation, on maintient le potentiel d'un conducteur de signaux ($X_0$ - $X_7$) au niveau dudit premier potentiel et on porte le potentiel des conducteurs de signaux restants ($X_0$ - $X_7$, DL) au niveau dudit second niveau de potentiel via lesdits transistors élémentaires (Cs).

**7.** Circuit décodeur selon la revendication 6, dans lequel on relie une extrémité de chaque conducteur de signaux d'entrée ($Y_0$ - $\overline{Y_2}$) à un transistor de commande respectif ($D_{IN}$), et on relie l'autre extrémité de chaque conducteur de signaux d'entrée ($Y_0$ - $\overline{Y_2}$) à un transistor de décharge respectif ($T_{DC}$), ledit transistor de commande ($D_{IN}$) étant commandé par lesdits signaux d'entrée ($A_0$ - $A_3$) et par ledit signal d'horloge ($\phi$) via les circuits correspondants de porte ET inversé ($NY_0$ - $NY_2'$) et via les circuits inverseurs ($INV_0$ - $INV_2$), et lesdits transistors de décharge ($T_{DC}$) étant commandés par ledit signal d'horloge via un circuit inverseur ($INV_5$).

**8.** Circuit décodeur selon l'une quelconque des revendications précédentes, dans lequel on relie l'électrode de la source de chaque transistor de transfert ($T_0$ - $T_7$) audit conducteur de signaux ($X_2$ - $X_7$, DL) adjacent dudit conducteur de signaux ($X_0$ - $X_7$) relié à l'électrode de la grille de ce transistor de transfert ($T_0$ - $T_7$).

**9.** Circuit décodeur selon la revendication 8, dans lequel on relie l'électrode de la source du dernier transistor de transfert ($T_7$) audit conducteur de signaux fictif (DL).

**10.** Circuit décodeur selon la revendication 8, dans lequel on relie l'électrode de la source du dernier transistor de transfert ($T_7$) au premier conducteur de signaux ($X_0$).

**11.** Circuit décodeur selon la revendication 8, dans lequel lesdits conducteurs de signaux ($X_0$ - $X_7$) sont divisés en paires de premier et second conducteurs de signaux de sortie adjacents ($X_0$, $X_1$; $X_2$, $X_3$; $X_4$, $X_5$; $X_5$, $X_7$), reliées aux électrodes des grilles des premier et second transistors de transfert ($T_0$, $T_1$; $T_2$, $T_3$; $T_4$, $T_5$; $T_6$, $T_7$), on relie la source d'un premier transistor de transfert ($T_0$; $T_2$; $T_4$; $T_6$) audit second conducteur de signaux de sortie ($X_1$; $X_3$; $X_5$; $X_7$), et on relie la source du second transistor de transfert ($T_1$; $T_3$; $T_5$; $T_7$) respectivement audit premier conducteur de signaux de sortie ($X_0$; $X_2$; $X_4$; $X_5$).

**12.** Circuit décodeur selon l'une quelconque des revendications précédentes, dans lequel on relie l'électrode du drain de chaque transistor de transfert ($T_0$ - $T_7$) à l'électrode du drain du transistor de préréglage respectif ($PRT_0$ - $PRT_7$) et à l'électrode de la grille du transistor de sortie respectif ($TR_0$ - $TR_7$), l'électrode de la source de chaque transistor de préréglage ($PRT_0$ - $PRT_7$) reçoit ledit premier potentiel d'alimentation ($V_{DD}$) et l'électrode de la grille de chaque tansistor de préréglage ($PRT_0$ - $PRT_7$) reçoit ledit signal d'horloge ($\phi$), et l'électrode de la source de chaque transistor de sortie ($TR_0$ - $TR_7$) reçoit ledit potentiel d'alimentation ($V_{DD}$) et on relie l'électrode du drain de chaque transistor de sortie ($TR_0$ - $TR_7$) à la borne de sortie respective ($O_0$ - $O_7$).

**13.** Circuit décodeur selon la revendication 12, dans lequel on dispose chaque transistor de transfert ($T_0$ - $T_7$), chaque transistor de préréglage ($PRT_0$ - $PRT_7$) et chaque transistor de sortie ($TR_0$ - $TR_7$) dans un espace adjacent entre lesdits conducteurs de signaux ($X_0$ - $X_7$, DL).

**14.** Circuit décodeur selon l'une quelconque des revendications précédentes, dans lequel tous lesdits transistors sont des transistors du type MIS.

**15.** Circuit décodeur selon la revendication 14, dans lequel ledit premier dispositif de réglage de potentiel (Tpc) comprend une pluralité de transistors de précharge MIS du type à canal - P, dans lequel ledit second dispositif de réglage de potentiel comprend une pluralité de transistors élémentaires MIS du type à canal N, et dans lequel chaque transistor de transfert ($T_0$ - $T_7$) est un transistor MIS du type à canal N.

**16.** Dispositif de mémoire morte (ROM) comprenant un circuit décodeur selon l'une quelconque des revendications précédentes.

# *Fig. I*

(INPUT SIGNAL)
ADDRESS SIGNAL $A_0 \sim A_2$

| DECODER PORTION (AND-TERM PORTION) | BUFFER PORTION | BIT BLOCK [ROM] (OR-TERM PORTION) |
| --- | --- | --- |
| | CONTROL PORTION | |

111  112  102

113

DECODER CIRCUIT 101

(OUTPUT SIGNAL)
BIT DATA

Fig. 2

# Fig. 3

CLOCK SIGNAL φ

INPUT SIGNAL A₀

INPUT SIGNAL A₁

INPUT SIGNAL A₂

OUTPUT SIGNAL
CONDUCTOR X₄

OUTPUT SIGNAL
CONDUCTOR
X₀~X₃ , X₅~X₇

TIMING SIGNAL T_C

WORD LINE WL₄

# Fig. 4

(INPUT SIGNAL)
ADDRESS SIGNAL $A_0 \sim A_2$

| 11 | 12 | 2 |
| --- | --- | --- |
| DECODER PORTION (AND-TERM PORTION) | BUFFER PORTION | BIT BLOCK [ROM] (OR-TERM ORTION) |

DECODER CIRCUIT 1

(OUTPUT SIGNAL)
BIT DATA

# Fig. 5

## Fig. 6

# Fig. 7

# Fig. 8

CLOCK SIGNAL φ

INPUT SIGNAL A₀

INPUT SIGNAL A₁

INPUT SIGNAL A₂

OUTPUT SIGNAL CONDUCTOR X₄

OUTPUT SIGNAL CONDUCTOR X₀~X₃ , X₅~X₇

WORD LINE WL₄